# EUROPEAN PATENT APPLICATION

(11) **EP 4 567 898 A1**
(43) Date of publication of application: **11.06.2025**
(21) Application number: 23215232.2
(22) Date of filing: 08.12.2023
(51) Int. Cl.: H01L 29/423, H01L 29/66, H01L 29/06, B82Y 10/00, H01L 29/10, H01L 29/78

(54) **FIELD-EFFECT TRANSISTOR ELEMENT AND QUANTUM COMPUTER DEVICE**

(71) Applicant: École Polytechnique Fédérale de Lausanne (EPFL), 1015 Lausanne (CH)
(72) Inventor: HAN, Hung-Chi, 1012 Lausanne (CH); JAZAERI, Farzan, 1022 Chavannes-Renens (CH); SALLESE, Jean-Michel, 1009 Pully (CH)
(74) Representative: Cohausz & Florack

(57) **Abstract**

A quantum dot device (100) for use as a qubit in a quantum computer is disclosed, comprising a channel region (106), a source region (108), a drain region (110), and at least two primary gate regions (120, 122, 124), wherein the at least two primary gate regions (120, 122, 124) are respectively provided with a main direction of extension (126, 128, 130) and disposed on a first surface of the channel region (106), and wherein the respective main directions of extension of the at least two primary gate regions are arranged substantially parallel to each other, at least one secondary gate region (118) having a main direction of extension (132) and disposed on a second opposite surface of the channel region (106), wherein the main direction of extension (132) of the at least one secondary gate region (118) is arranged substantially orthogonally to the respective main directions of extension (126, 128, 130) of the at least two primary gate regions (120, 122, 124). The device may also be formed in a non-planar semiconductor body, like a fin, see figure 6.

## Description

The present invention relates to a field-effect transistor element comprising a channel region, a source region, a drain region, and at least two primary gate regions, wherein the at least two primary gate regions are respectively provided with a main direction of extension, and wherein the respective main directions of the at least two primary gate regions are arranged substantially parallel to each other. The present invention further relates to a quantum computer device.

Quantum bits or qubits, available for storing information, are incredibly fragile, unstable, and difficult to scale due to their interactions with uncontrolled degrees of freedom of the external environment. In the worldwide quest for practical implementation of the quantum-computing paradigm, researchers have come up with several physical realizations of the fundamental building block of quantum computers called a quantum bit, or qubit. Photonics, trapped ions, Liquid-state nuclear-magnetic-resonance, and scalable solid-state qubits such as superconducting qubits and semiconductors qubits were among the earliest studied. The physical implementation of solid-state qubits has recently attracted much attention owing to their potential to be integrated on a large scale. For instance, superconducting qubits are the building block of D-wave quantum computers and the focus of attention of recent research activities on quantum computing. However, the superconducting qubits suffer from scaling limitations since the superconducting coherence length limits their dimensions.

Recently, several research activities have aimed at realizing silicon-based spin qubits within a full complementary metal-oxide-semiconductor, CMOS, platform and developing CMOS-based cryogenics electronics. As an example, in the case of double-gate silicon on insulator nanowire field-effect transistor or DG-SOI-NWFET, parallel gates are employed to form a single or double quantum dot system with tunable tunnel barriers and to leverage the Coulomb Blockade effect. In lateral double-gate SOI FinFET or LDG-SOI-FinFET, two wide top-gates are laterally located and partially cover the channel. In the case of split face-to-face double gate SOI FinFET or SDG-SOI-FinFET, one-dimensional conduction is formed at the two upper edges of the silicon channel. Electron localization along the upper edges of the silicon channel is achieved, leading to independently controlled quantum dots usually referred to as "corner dots".

Nowadays, the CMOS-compatible qubits with the nanowire structure are widely used in academic research, which allows sufficient energy discrepancy in electron/hole states thanks to its low dimension. Although the nanowire field-effect transistors have been studied by academia and industry for years, the mature technology is not available yet in industrial manufacture. In particular, the variability of nanowire-structure devices is the major issue. The qubits hosted in nanowires hence face many challenges in the commercialization phase. Moreover, the proposed structures are not the most convenient design in terms of producibility and require fabricating 1D nanowire quantum wire. This, in turn, means overcoming the current process challenges for the physical implementation of a 1D nanowire.

Against this background, it is an object of the present invention to provide a field-effect transistor element or qubit with improved design in terms of scalability, producibility, and reliability, in particular for high-density three-dimensional integration.

The object named above is solved in accordance with the present disclosure by a field-effect transistor element comprising a channel region, a source region, a drain region, and at least two primary gate regions, wherein the at least two primary gate regions are respectively provided with a main direction of extension, and wherein the respective main directions of the at least two primary gate regions are arranged substantially parallel to each other, characterized in that at least one secondary gate region having a main direction of extension is provided, and in that the main direction of extension of the at least one secondary gate region is arranged substantially orthogonally to the respective main directions of extension of the at least two primary gate regions.

Such a field-effect transistor element allows for forming electrostatically, depending on the number of primary gate regions, at least one zero-dimensional quantum dot in the channel region. In particular, the proposed field-effect transistor element with multi-gate configuration allows for using potential confinement instead of using physical confinement for hosting qubits.

One of the limitations of spin qubit is the small spacing level between ground and excited states of a quantum dot. Such a spacing level is strongly correlated to the device structure. The small spacing level results in a spin state that is sensitive to the environment such as thermal and field fluctuation. Numerical simulations surprisingly show that, when simulating applying positive bias on the at least two primary gate regions and negative bias on the at least one secondary gate region of the disclosed field-effect transistor element, a high energy difference can be observed between the ground state and the first excited state. As an example, an energy spacing between ground and excited states of a quantum dot achieved with the proposed field-effect transistor element has been calculated to be more than 40 times larger than the thermal energy constated for the same material combination at 4 K, which is kT/q in eV with k the Boltzmann constant, T the temperature, and q the elementary charge, indicating that the proposed field-effect transistor element has enhanced resistance to fluctuation of environmental parameters. Accordingly, the proposed field-effect transistor element allows for achieving a so-called "hot spin quantum bit".

Furthermore, such a field-effect transistor element can be produced with a complementary metal-oxide-semiconductor, CMOS, method. CMOS methods are advanced and well-established processes that rely on existing semiconductor technological tools which can offer great miniaturization possibilities at a level of control and reproducibility necessary for large-scale integration of qubits. Accordingly, with the proposed field-effect transistor element allows an industrial manufacture of CMOS spin qubits can be streamlined while keeping sufficient energy discretization in a qubit.

Ultimately, a hot CMOS spin qubit can be achieved with improved design in terms of scalability, producibility, and reliability, in particular for high-density three-dimensional integration.

A "region " in the meaning of the present disclosure, such as a channel region, a source region, a drain region, a primary gate region, a secondary gate region or a fin region, may correspond to a zone or part of the field-effect transistor element having an individual function for creating one or a plurality of quantum dot(s). As an example, a channel region may be a zone of a material layer or film arranged between a source region and drain region in one spatial direction, and between a primary gate region and a secondary gate region in another spatial direction.

The field-effect transistor element may comprise a metal-oxide-semiconductor structure, or MOS, comprising a metal, an oxide, and a semiconductor. In particular, the field-effect transistor element may be a so-called MOSFET.

The channel region is arranged between the at least two primary gate regions on the one hand, and the at least one secondary gate region on the other hand. This way, and by applying voltage to the at least two primary gate regions and the at least one secondary gate region the channel region can electrostatically act as a nano-wire-like channel, in particular due to low dimensions of the at least one secondary gate region. The at least one secondary gate region may be larger or thinner than the length of the at least two primary gate regions. The at least one secondary gate region may be arranged centered with regard to the length of the at least two primary gate regions or may be off centered with regard to the length of the at least two primary gate regions.

Preferably, the source region and the drain region are arranged opposite to each other and are in contact with the channel region, respectively. The at least two primary gate regions are preferably connected to the channel region by at least one region comprising a dielectric material.

At least two primary gate regions are provided. A primary gate region may comprise polysilicon, a silicide material, or metal composites, such as WN, TiN, or TaN . A primary gate region may be substantially formed as a layer, as a bar or as a fin. The at least two primary gate regions are respectively provided with a main direction of extension. When a primary region is substantially formed as a bar, the main direction of extension is parallel to the direction, in which the bar exhibits the longest dimension, e.g. in length. When a primary region is substantially formed as a layer or as a fin, the main direction of extension may be comprised in a geometric plane parallel to the length and the width of the layer or of the fin. The respective main directions of the at least two primary gate regions are arranged substantially parallel to each other. In particular, the at least two primary gate regions may be formed and disposed in such a manner that the at least two primary gate regions do not enter into direct contact with each other.

At least one secondary gate region is provided. A secondary gate region may comprise at least one of polysilicon, doped silicon, or metal composites, such as WN, TiN or TaN. A secondary gate region may be substantially formed as a layer, as a bar or as a fin. In a particular exemplary embodiment, the at least one secondary gate region may be a region of a fin, bar, or layer, wherein the region covers the totality of the volume of the fin, bar, or layer or, alternatively, wherein the region covers only partially the volume of the fin, bar, or layer.

The at least one secondary gate region is provided with a main direction of extension. When a secondary region is substantially formed as a bar, the main direction of extension is parallel to the direction, in which the bar exhibits the longest dimension, e.g. in length. When a secondary region is substantially formed as a layer or as a fin, the main direction of extension may be comprised in a geometric plane parallel to the length and the width of the layer or of the fin.

The field-effect transistor element may be produced with a method comprising at least two phases, wherein the at least two phases comprise an extreme-ultra-violet-based (EUV-based) treatment phase and an e-beam lithography phase. The dimension engineering from EUV to e-beam lithography allow for providing discrete energy analysis with respect to the size of the quantum dot.

The object named above is further solved in accordance with the present invention by a quantum computer device comprising at least one field-effect transistor element according to the present disclosure.

Various embodiments of the field-effect transistor element and the quantum computer device are described in the following. The individual embodiments are in each case individually applicable to the and the quantum computer device. The individual embodiments may furthermore be combined with each other at will.

An exemplary embodiment of the field-effect transistor element is characterized in that the at least two primary gate regions comprise N primary gate regions, wherein N is equal or greater than 2, and in that the N primary gate regions, the channel region and the at least one secondary gate region, are configured to, when the N primary gate regions are provided with a positive electrical bias and the at least one secondary gate region is provided with a negative electrical bias, cause N-1 electrostatic confinement(s) of holes in the channel region, wherein the respective N-1 electrostatic confinement(s) of holes correspond to a quantum dot in the valence band of the channel region, respectively.

As already mentioned above, the proposed field-effect transistor element allows for forming at least one zero-dimensional quantum dot electrostatically by the orthogonal disposition of the primary gate regions and the at least one secondary gate region. The parallel primary gate regions are spaced from each other, forming at least one quantum well for holes when the positive voltage is applied to the front gate.

Conversely, the negative bias applied at the at least one secondary gate region inverses the holes in the channel. Consequently, a quantum dot system is formed by trapping holes into the low-dimensional quantum well. There are as many quantum wells formed as spacings between neighboring secondary gate regions.

Conversely, the proposed field-effect transistor element allows for hosting hole spins in a reliable nano-structure. The variability of the proposed field-effect transistor element is potentially higher than nanowire-based quantum devices. Additionally, due to the nature of hole spin, it has weaker hyperfine interaction of nuclear spins, the absence of degenerate valleys, and strong spin-orbit interaction. These facts suggest that hole spins have promising scalability compared to electron spins.

The N primary gate regions, the channel region and the at least one secondary gate region may be provided with material composition, dimension and spatial arrangement chosen for causing electrostatic confinement of holes in the channel region.

An exemplary embodiment of the field-effect transistor element is characterized in that the at least two primary gate regions are arranged spaced at a distance Lₛₚₓ from each other, wherein the distance Lₛₚₓ is comprised in the range of 0 to 30 nm, in particular in the range of 5 to 25 nm, more particularly in the range of 5 to 20 nm, preferably in the range of 5 to 15 nm, more preferably in the range of 7 to 13 nm.

The low dimension applied to the distance Lₛₚₓ is for creating the quantum confinement or quantum dot that hosts a few holes, regarded as artificial atoms. The distance Lₛₚₓ is a critical dimension since it defines the size of the quantum dot in the x-direction. The discrete energy spacing of a quantum dot is inversely proportional to the square of the dimension. The lower the dimension, the higher the energy spacing between discrete levels. Hence, due to the nature of quantum mechanics, it is preferred to have a quantum dot built in the lowest dimension. However, the dimension Lₛₚₓ is defined by the lithographic patterning. Currently, three main lithography processes using different light sources, including deep UV (DUV), extreme UV (EUV), and electron-beam (e-beam) are known. Each process has its own minimum patterning dimension. DUV is about 35 nm, EUV is around 13 nm, and e-beam can go below 10 nm. This is the physical and technical reason to justify the critical dimension used in the present disclosure.

An exemplary embodiment of the field-effect transistor element is characterized in that the at least two primary gate regions comprise a first primary gate region, a second primary gate region and a third primary gate region, wherein the second primary gate region is arranged between the first primary gate region and the third primary gate region, and wherein the second primary gate region has a dimension Lₓ in a direction substantially orthogonal to its respective main direction of extension, wherein the dimension Lₓ is comprised in the range of 0 to 35 nm, in particular in the range of 0 to 30 nm, more particularly in the range of 0 to 20 nm, preferably in the range of 0 to 10 nm, particularly in the range of 7 to 13 nm.

The dimension Lₓ represents the physical distance between two neighboring quantum dots formed when more than two primary gate regions are provided. If the dimension Lₓ is too large, e.g., greater than 35 nm, the interaction between the two neighboring quantum dots would be weakened. The range for the dimension Lₓ is chosen in function of the temperature. It is preferable to use a minimum value for the dimension Lₓ, allowing the field-effect transistor element to work at higher temperatures with an optimized power budget. Overall, the proposed value ranges for the dimension Lₓ are a trade-off between dependence on the temperature, bias applied to the at least two primary gate regions, respectively, and technology or production limitation.

An exemplary embodiment of the field-effect transistor element is characterized in that the at least two primary gate regions are arranged spaced at a distance Lₛₚₓ from each other, in that the at least two primary gate regions comprise a first primary gate region, a second primary gate region and a third primary gate region, wherein the second primary gate region is arranged between the first primary gate region and the third primary gate region, and wherein the second primary gate region has a dimension VGI in a direction substantially orthogonal to its respective main direction of extension, and in that the product of a division of the distance Lₛₚₓ by the distance VGI is comprised in the range from 0.25 to 1.25, in particular in the range from 0.5 to 1.

An exemplary embodiment of the field-effect transistor element is characterized in that the at least two primary gate regions are arranged spaced at a distance Lₛₚₓ from each other, in that the at least one secondary gate region has a dimension W_{bg} in a direction substantially orthogonal to its respective main direction of extension, and in that the product of a division of the distance W_{bg} by the distance Lₛₚₓ is comprised in the range from 0.25 to 1.25, in particular in the range from 0.5 to 1.

These value ranges proposed allow for a larger field of application, in particular in view of temperature and voltage or bias applied to the gate regions, as well as a reasonable implementation regarding available production technologies.

In a particular exemplary embodiment of the field-effect transistor element, the dimension W_{bg} is comprised in the range of 0 to 30 nm, in particular in the range of 0 to 25 nm, more particularly in the range of 0 to 20 nm, preferably in the range of 7 to 13 nm, more preferably substantially equal to 10 nm. In particular, the dimension W_{bg} may be comprised in a similar value range as the dimension Lₛₚₓ, and the same advantages apply for W_{bg} and for Lₛₚₓ.

The at least one secondary gate region allows for electrostatically creating a nano-wire-like channel thanks to its low dimension.

An exemplary embodiment of the field-effect transistor element is characterized in that the channel region comprises a silicon-germanium alloy and / or isotopically purified silicon isotope ²⁸Si.

Isotopically purified silicon ²⁸Si allows a longer dephasing time due to the absence of nuclear spin interaction. It makes the silicon quantum dot a promising implementation for the quantum computer. Using a silicon-germanium alloy or SiGe alloy allows for using already available FDSOI production processes.

An exemplary embodiment of the field-effect transistor element is characterized in that a layer body is provided with a front side and a back side arranged opposite to each other, in that the at least two primary gate regions are arranged at the front side of the layer body, and in that the at least one secondary gate region is arranged at the back side of the layer body.

Such a disposition of the at least two primary gate regions and of the at least one secondary gate region offers a pathway to take advantage of the standard process flow used to fabricate multi-gate SOI FETs for spin qubits and to reach higher densities and efficiencies in comparison to known MOSFET structures.

Furthermore, the application of positive bias on the at least two primary gate regions and of negative bias on the at least one secondary gate region allows for hosting at least one quantum dots in the channel region.

An exemplary embodiment of the field-effect transistor element is characterized in that the layer body comprises a front dielectric layer, the source region, the drain region, the channel region and a back dielectric layer, wherein the front dielectric layer is arranged at the front side of the layer body, the back dielectric layer is arranged at the back side of the layer body, and the channel region is arranged between the front dielectric layer and the back dielectric layer, in that the channel region has a thickness t_{ch}, in that the at least two primary gate regions are arranged spaced at a distance Lₛₚₓ from each other, in that the product of a division of the distance Lₛₚₓ by the thickness t_{ch} is comprised in the range from 0.25 to 2.25, in particular in the range from 0.5 to 2.

The thickness t_{ch} is relatively critical, since it effects a confinement of the quantum dot in the direction extending from the front side of the layer body to the back side of the layer body. The relation between the distance Lₛₚₓ, through which a confinement of the holes in the direction between the primary gate regions, and the thickness t_{ch} determines the overall spatial confinement of the quantum dot or for the trapped holes.

In a particular exemplary embodiment, the front dielectric layer, the channel region, and the back dielectric layer are respectively provided with a main direction of extension, wherein the respective main directions of the front dielectric layer, the channel region and the back dielectric layer are arranged substantially parallel to each other, and the channel region has a dimension t_{ch} in a direction substantially orthogonal to its main direction of extension.

In a particular exemplary embodiment, the thickness t_{ch} is comprised in the range of 0 to 20 nm, in particular in the range of 0 to 10 nm, more particularly in the range of 2 to 8 nm. The thickness t_{ch} is conditioned by the limitation of the manufacture process. As an example, current known commercial SOI wafer may be provided with a value of t_{ch} round 6 nm. In principle, the thinner t_{ch}, the better confinement is achieved. That makes the energy spacing level even larger.

In various dielectric implementations available today, it is common to use a generalized dimension called "effective thickness" for characterizing the front dielectric layer. The effective thickness corresponds to the physical dielectric thickness multiplied by a fraction of the material dielectric constant to SiO2 dielectric constant. As an example, an effective thickness of about 1.2 nm may be used.

An exemplary embodiment of the field-effect transistor element is characterized in that the field-effect transistor element is the product of a fully depleted silicon on insulator, FD-SOI, method.

A FD-SOI method may comprise at least two actions, wherein a first action comprises providing an ultra-thin layer of oxide material, called the buried oxide, on top of a gate stack, wherein the gate stack may comprise at least one of: a dielectric material, a semiconductor material or an insulator material. Then, in a further action, a thin layer of semiconductor material may be provided on top of the oxide material. Such a FD-SOI method may be implemented as Ultra-thin Body and Buried oxide Fully Depleted SOI method or UTBB-FD-SOI method. In an exemplary embodiment, the gate stack comprises the at least one secondary gate region, the oxide material or buried oxide corresponds to the back dielectric layer, and the thin layer of semiconductor material comprises the channel region. The thinness of the layer of semiconductor material or channel region allows for omitting material doping in the channel region. A resulting field-effect transistor element is then called "fully depleted".

By construction, FD-SOI enables much better transistor electrostatic characteristics versus conventional bulk technology. The buried oxide layer lowers the parasitic capacitance between the source and the drain. It also efficiently confines the electrons flowing from the source to the drain, dramatically reducing performance-degrading leakage currents. In bulk technology, body biasing is very limited, due to parasitic current leakage and inefficiency at reduced transistor geometry. Thanks to the transistor construction in FD-SOI and its ultra-thin insulator layer, biasing is much more efficient. Also, the presence of the buried oxide allows the application of higher biasing voltages, resulting in breakthrough dynamic control of the transistor. Further, FD-SOI produced field-effect transistors can be switched faster in comparison to field-effect transistor produced with conventional bulk technology. This allows for optimizing performance and power consumption.

An alternative exemplary embodiment of the field-effect transistor element is characterized in that a bulk body is provided with a front side, and in that the at least two primary gate regions and the at least one secondary gate region are arranged at the front side of the bulk body.

Accordingly, electrical bias for producing quantum dots can be applied to the gate regions regardless of the dimension, in particular thickness, of the bulk body. This may be relevant when implementing the field-effect transistor element in an electrical circuit or electronic platform or device.

FinFET has a bulk body, wherein the body effect of the FinFET structure can be negligible and the thickness of the bulk body is not critical. The quantum dots are formed in the channel region. In comparison, quantum dots can also be formed in a bulk-MOSFET-based structure, where the channel region is at the top region of the bulk body. For quantum dot devices manufactured in bulk-MOSFET-based structure, applying a strong bias can create the quantum confinement vertically. Therefore, the confinement is not related to the thickness of the bulk body. However, the bulk method may lead to several issues compared to FinFET and FDSOI; (1) the electrostatic control is less efficient, (2) the high gate voltage may lead to the strong mobility degradation by the surface roughness scattering, and (3) high supply voltage and high-power consumption for the peripheral circuit of the quantum dot device. These disadvantages are overcome with a FinFET or FDSOI-base structure.

An exemplary embodiment of the field-effect transistor element is characterized in that a primary gate region of the at least two primary gate regions is arranged substantially in a primary main extension plane comprising the respective main direction of extension of the primary gate region, in that a secondary gate region of the at least one secondary gate region is arranged substantially in a secondary main extension plane comprising the respective main direction of extension of the secondary gate region, in that a fin region with a main direction of extension is provided and arranged substantially in a tertiary main extension plane comprising the main direction of extension of the fin region, in that the primary main extension plane is substantially orthogonal to the secondary main extension plane and to the tertiary main extension plane, and in that the secondary main extension plane is substantially orthogonal to the tertiary main extension plane.

In particular, the fin region may comprise the channel region. Accordingly, at least one electrostatically defined quantum dot can be provided in the fin region. The proposed field-effect transistor element may be produced with known methods for producing a Fin Field-Effect Transistor, FinFET.

According to the present exemplary embodiment, the at least two primary gate regions, the at least one secondary gate region and the fin region form an orthogonal system.

An exemplary embodiment of the field-effect transistor element is characterized in that the fin region has a dimension F_{w} in a direction substantially orthogonal to the tertiary main extension plane, in that the at least two primary gate regions are arranged spaced at a distance Lₛₚₓ from each other, and in that the product of a division of the distance Lₛₚₓ by the dimension F_{w} is comprised in the range from 0.25 to 2.25, in particular in the range from 0.5 to 2.

The dimension Fw also corresponds to the thickness of the channel region and effects a confinement of the quantum dot in the direction orthogonal to the spacing of the primary gate regions. The relation between the distance Lₛₚₓ, through which a confinement of the holes in the direction between the primary gate regions, and the dimension Fw determines the overall spatial confinement of the quantum dot or for the trapped holes.

In a particular exemplary embodiment, the dimension Fw is comprised in the range of 0 to 20 nm, in particular in the range of 0 to 10 nm, more particularly in the range of 2 to 8 nm. The dimension Fw is conditioned by the limitation of the manufacture process. In principle, the thinner the dimension Fw, the better confinement is achieved. That makes the energy spacing level even larger.

Further features and advantages of the field-effect transistor element and the quantum computer device emerge from the following description of exemplary embodiments where reference is made to the attached drawing.

In the drawing
- Fig. 1: shows a first exemplary embodiment of a field-effect transistor element in a perspective view;
- Fig. 2: shows the field-effect transistor element of fig. 1 in a sectional view;
- Fig. 3: shows the field-effect transistor element of fig. 1 in a bottom view;
- Fig. 4: shows the field-effect transistor element of fig. 1 in a sectional view with a schematic representation of two exemplary energy distributions over the width of the field-effect transistor of fig. 1;
- Fig. 5: shows a second exemplary embodiment of a field-effect transistor element in a perspective view;
- Fig. 6a: shows a third exemplary embodiment of a field-effect transistor element in a first perspective view;
- Fig. 6b: shows the field-effect transistor element of fig. 6a in a second perspective view;
- Fig. 7: shows the field-effect transistor element of fig. 6a in a sectional view with a schematic representation of energy distribution over the width of the field-effect transistor.

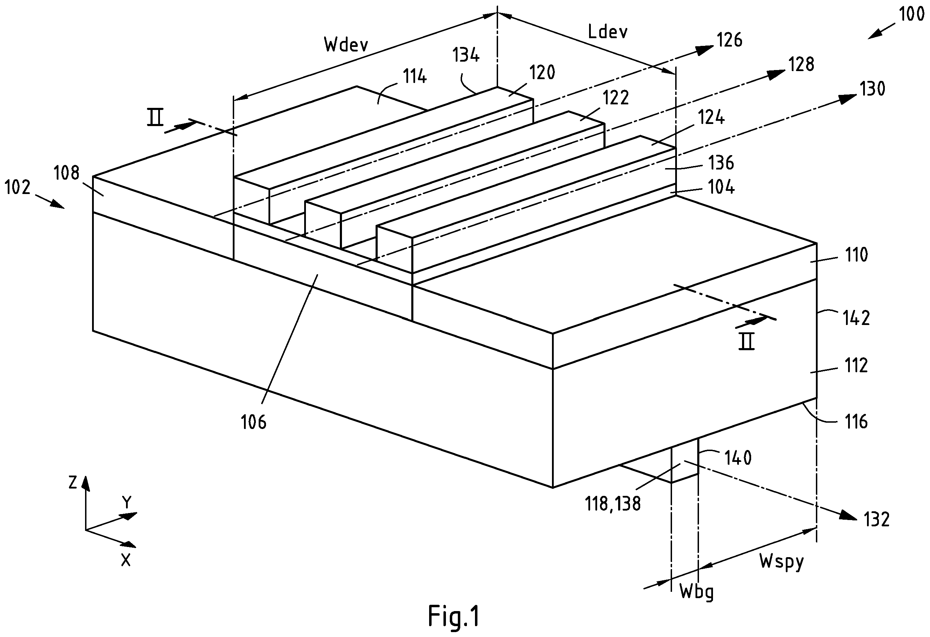

Fig. 1 shows a first exemplary embodiment of a field-effect transistor element 100 in a perspective view. The field-effect transistor element 100 comprises a layer body 102 with a front dielectric layer 104, a channel region 106, a source region 108, a drain region 110 and a back dielectric layer 112. The layer body 102 is formed with a front side 114 and a back side 116 arranged opposite to each other. The front dielectric layer 104 is arranged at the front side 114 of the layer body 102 and the back dielectric layer 112 is arranged at the back side 116 of the layer body 102. The channel region 106 is arranged between the front dielectric layer 104 and the back dielectric layer 112.

The field-effect transistor element 100 further comprises three primary gate regions 120, 122, 124 and a secondary gate region 118. The three primary gate regions 120, 122, 124 comprise a first primary gate region 120, a second primary gate region 122 and a third primary gate region 124, and wherein the second primary gate region 122 is arranged between the first primary gate region 120 and the third primary gate region 124. The three primary gate regions 120, 122, 124 are arranged at the front side 114 of the layer body 102 and are respectively provided with a main direction of extension 126, 128, 130, wherein the respective main directions of the three primary gate regions 120, 122, 124 are arranged substantially parallel to each other. The secondary gate region 118 has a main direction of extension 132 and is arranged at the back side 116 of the layer body 102, the main direction of extension 132 of the secondary gate region 118 being arranged substantially orthogonally to the respective main directions of extension of the three primary gate regions 120, 122, 124. The field-effect transistor element 100 is represented in such a perspective that the main direction of extension 126, 128, 130 of the respective primary gate regions 120, 122, 124 are oriented in a y direction of a three-dimensional orthogonal spatial system, and that the main direction of extension 132 of the secondary gate region 118 is oriented along the x axis of the same spatial system. The z axis of the spatial system extends in the direction from the back side 116 of the layer body 102 toward the front side 114 of the layer body 102.

The secondary gate region 118 is arranged below the primary gate regions 120, 122, 124 the z axis and the channel region 106 is arranged between the primary gate regions 120, 122, 124 and the secondary gate region 118.

The distance between the left side 134 of the first primary gate region 120 and the right side 136 of the third primary gate region 124 along the x-axis is the length of the field-effect transistor element 100, L_{dev}. The width of the field-effect transistor element 100, W_{dev}, corresponds to the length of the primary gate regions 120, 122, 124 in the y-axis. The secondary gate region 118 is comprised by a gate material part 138 of the field-effect transistor element 100, wherein the gate material part 138 has a width W_{bg} along the y axis. The distance between a side edge 140 of the gate material part 138 comprising the secondary gate region 118 and an edge 142 of the field-effect transistor element 100 is W_{spy}. The represented field-effect transistor element 100 has a distance W_{spy} along the y axis being different zero.

The three primary gate regions 120, 122, 124 comprise poly silicon; the front dielectric layer 104 and the back dielectric layer 112 comprise silicon-oxide, SiO₂, respectively; the channel region 106 comprises isotopically purified ²⁸Si, the source region 108 and the drain region 110 comprise doped silicon, respectively; the secondary gate region 118 comprises doped silicon.

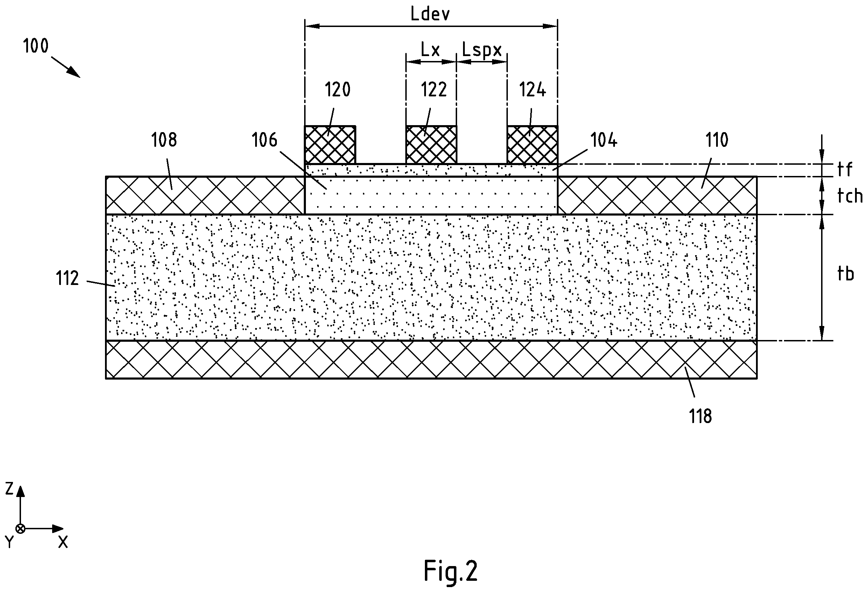

Fig. 2 shows the field-effect transistor element 100 of fig. 1 in a sectional view in a plane parallel to the z and x axis of the three-dimensional orthogonal spatial system of the fig. 1. The three primary gate regions 120, 122, 124 are represented with a substantially similar width along the x-axis or along the main direction of extension 132 of the secondary gate region 118. However, this representation is not limiting for the scope of the present disclosure and the primary gate regions 120, 122, 124 may be provided with different dimensions. The second primary gate region 122 has a width Lₓ of around 10 nm along the x-axis or along main direction of extension 132 of the secondary gate region 118.

The three primary gate regions 120, 122, 124 are arranged spaced at a distance Lₛₚₓ from each other along the x-axis. The distance Lₛₚₓ between the second primary gate region 122 and the third primary gate region 124 of the represented of the field-effect transistor element 100 is around 10 nm.

The front dielectric layer 104 has an effective thickness t_{f} in the z axis of around 1.2 nm. The channel region 106 has a thickness t_{ch} in the z axis of around 6 nm. The back dielectric layer 112 has a thickness t_{b} in the z axis of around 20 nm.

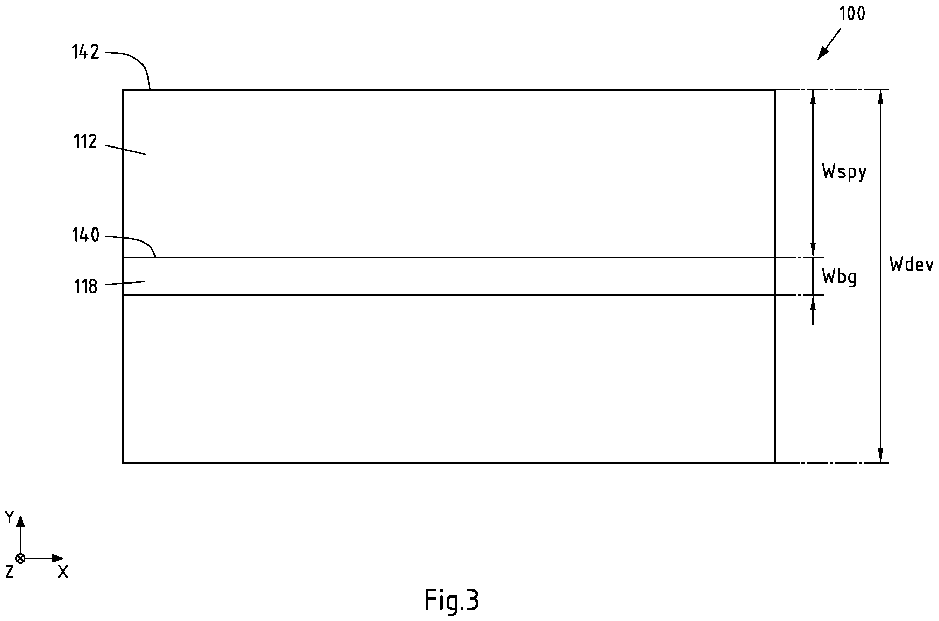

Fig. 3 shows the field-effect transistor element 100 of fig. 1 in a bottom view, wherein the width of the field-effect transistor element 100, W_{dev}, in the y axis is represented. The width W_{dev} is around 80 nm and corresponds to the minimum width of a commercial FDSOI process. The width W_{dev} may be provided smaller than 80 nm. The width of the secondary gate region 118 along the y axis is W_{bg}, wherein the width W_{bg} is around 10 nm.

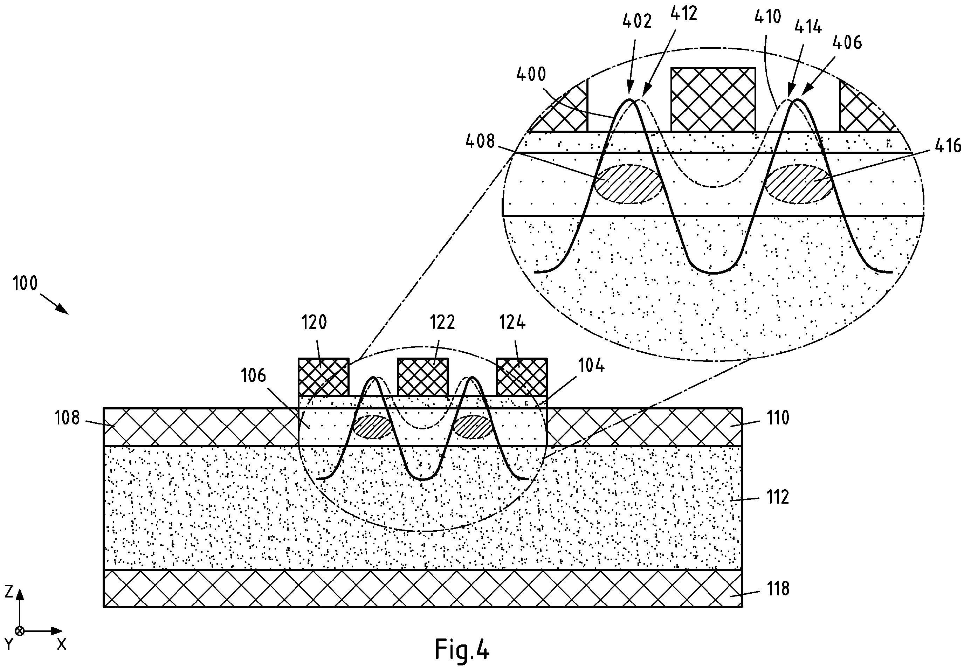

Fig. 4 shows the field-effect transistor element 100 of fig. 1 in a sectional view in a plane comprising the x and z axis of the orthogonal spatial system of fig. 1, wherein a schematic representation of two exemplary energy distributions 400, 410 over the width W_{dev} of the field-effect transistor of fig. 1 in the x direction are reported.

A first exemplary energy distribution 400 corresponds to the case when a first voltage is applied to the first primary gate region 120, a second voltage is applied to the second primary gate region 122, a third voltage is applied to the third primary gate region 124 and a fourth voltage is applied to the secondary gate region 118, wherein the first voltage, the second voltage and the third voltage are positive and substantially equal, e.g. to around + 1 V, and wherein the fourth voltage is negative, e.g. has a value around - 6 V.

A second exemplary energy distribution 410 corresponds to the case when a first voltage is applied to the first primary gate region 120, a second voltage is applied to the second primary gate region 122, a third voltage is applied to the third primary gate region 124 and a fourth voltage is applied to the secondary gate region 118, wherein the first voltage and the third voltage are positive and substantially equal, wherein the second voltage is smaller than both the first voltage and the third voltage, and wherein the fourth voltage is negative.

For both cases, two peak regions 402, 404 and 412, 414 can be observed in the energy distribution curves respectively, wherein a first peak region is localized between the first primary gate region 120 and the second primary gate region 122, and wherein a second peak region is localized between the second primary gate region 122 and the third primary gate region 124. The first peak region indicates a first quantum dot 408 in the valence band of the channel region 106 and the second peak region indicates a second quantum dot 416 in the valence band of the channel region 106.

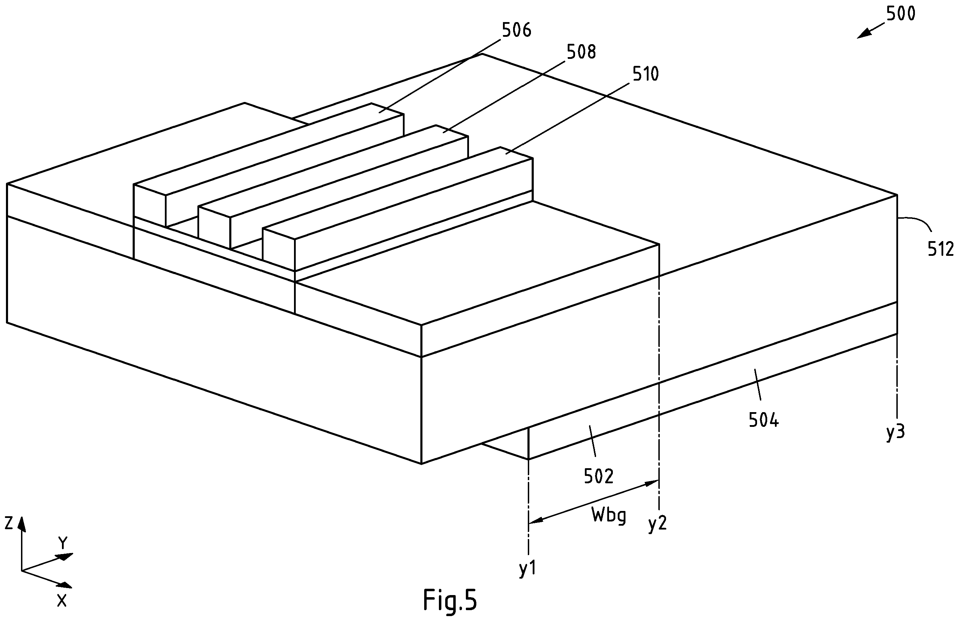

Fig. 5 shows a second exemplary embodiment of a field-effect transistor element 500 in a perspective view. The field-effect transistor element 500 of fig. 5 has a similar configuration as the field-effect transistor element 100 of fig. 1, except for the width of the secondary gate region 502. In fig. 5, the field-effect transistor element 500 has a gate material part 504 comprising the secondary gate region 502, wherein the gate material part 504 extends from a position y1 to a position y3 in the y direction. The secondary gate region 502 corresponds to a zone of the gate material part 504 arranged below the three primary gate regions 506, 508, 510 in the z axis, and the secondary gate region 502 extends from the position y1 to a position y2 on the y axis, wherein y2 is comprised between y1 and y3 in the y direction. The distance from the position y1 to the position y2 corresponds to the width of the secondary gate region 502, W_{bg}, in the y direction. The distance from the position y3 to the edge 512 of the field-effect transistor element 500 corresponds to a distance W_{spy}. Unlike the case of the field-effect transistor element 100 of fig. 1, the distance W_{spy} for the field-effect transistor element 500 of fig. 5 is zero.

From the fabrication point of view, the implementation of the back gate is easier when the distance W_{spy} = 0, as shown in fig. 5. This way, the width of the secondary gate region 502, W_{bg}, corresponds to the width of a region of the gate material part 504 being arranged below the primary gate regions 506, 508, 510 in the z direction. An advantage of such a configuration of the field-effect transistor element 500 and in particular of the represented secondary gate region 502 is that the gate material part 504 may be provided with larger dimensions in comparison to the secondary gate region 502, thus facilitating the production and reproducibility. In other word, an implementation of the secondary gate region 502 as nanowire may be avoided while keeping the advantageous properties of a nanowire.

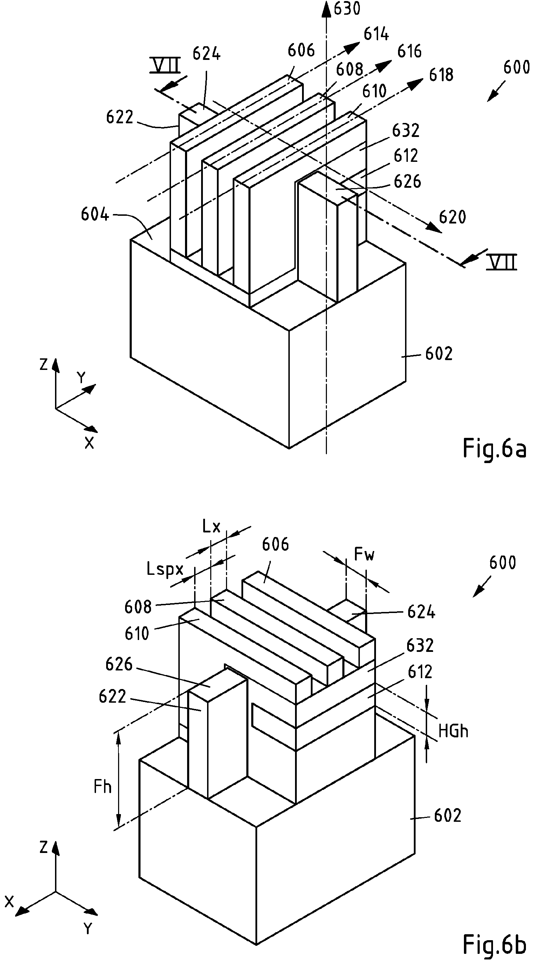

Fig. 6a and 6b show a third exemplary embodiment of a field-effect transistor element 600 in a first perspective view and in a second perspective view, respectively. The field-effect transistor element 600 has a bulk body 602 provided with a front side 604. The field-effect transistor element 600 is further provided with, on the one hand, three primary gate regions 606, 608, 610 comprising a first primary gate region 606, a second primary gate region 608 and a third primary gate region 610, and, on the other hand, a secondary gate region 612. The three primary gate regions 606, 608, 610 and the secondary gate region 612 are arranged at the same side of the bulk body 602.

The three primary gate regions 606, 608, 610 are respectively provided with a main direction of extension 614, 616, 618, wherein the respective main directions of the three primary gate regions 606, 608, 610 are arranged substantially parallel to each other. The secondary gate region 612 extends with a main direction of extension 620 which is arranged substantially orthogonally to the respective main directions of extension 614, 616, 618 of the three primary gate regions 606, 608, 610.

The field-effect transistor element 600 is further provided with a fin region 622 comprising a source region 624, a drain region 626 and a channel region 628. The fin region 622 has a main direction of extension 630 which is substantially orthogonal to, on the one hand, the respective main directions of extension 614, 616, 618 of the primary gate regions 606, 608, 610 and, on the other hand, to the main direction of extension 620 of the secondary gate region 612. In particular, the respective main directions of extension 614, 616, 618 of the primary gate regions 606, 608, 610 are respectively substantially parallel to an y axis of an orthogonal three-dimensional reference system, the main direction of extension 620 of the secondary gate region 612 is substantially parallel to an x axis of the same reference system and the main direction of extension 630 of the fin region 622 is substantially parallel to a z axis of the same reference system. Also, the primary gate regions 606, 608, 610 are respectively substantially arranged in a primary plane of extension parallel to the y axis and the z axis of the three-dimensional reference system, the secondary gate region 612 is substantially arranged in a secondary plane of extension parallel to the x axis and the y axis of the three-dimensional reference system, and the fin region 622 is substantially arranged in a tertiary plane of extension parallel to the x axis and the z axis of the three-dimensional reference system.

The field-effect transistor element 600 further comprises a dielectric region 632, wherein the dielectric region 632 is provided to separate the respective primary gate regions 606, 608, 610 from the fin region 622 or channel region 628 on the one hand, and to separate the secondary gate region 612 from the fin region 622 on the other hand.

The three primary gate regions 606, 608, 610 are represented with a substantially similar width along the x-axis or along the main direction of extension 620 of the secondary gate region 612. However, this representation is not limiting for the scope of the present disclosure and the primary gate regions 606, 608, 610 may be provided with different dimensions. The second primary gate region 608 has a width Lₓ of around 10 nm along the x-axis or along main direction of extension 620 of the secondary gate region 612.

The three primary gate regions 606, 608, 610 are arranged spaced at a distance Lₛₚₓ from each other along the x-axis. The distance Lₛₚₓ between the second primary gate region 608 and the third primary gate region 610 of the represented of the field-effect transistor element 600 is around 10 nm.

The fin region 622 has a dimension F_{w} of around 10 nm in the x direction, also corresponding to the dimension of the channel region 628 in the x direction. The fin region 622 has a dimension Fₕ of around 50 nm in the z direction. The secondary gate region 612 has a dimension HGh of around 10 nm in the z direction.

The three primary gate regions 606, 608, 610 and the secondary gate region 612 comprise poly silicon; the dielectric region 632 comprises silicon dioxide, SiO₂; the fin region 622 comprises isotopically purified ²⁸Si; the bulk body 602 comprises silicon; the drain region 626 and the source region 624 comprise doped silicon.

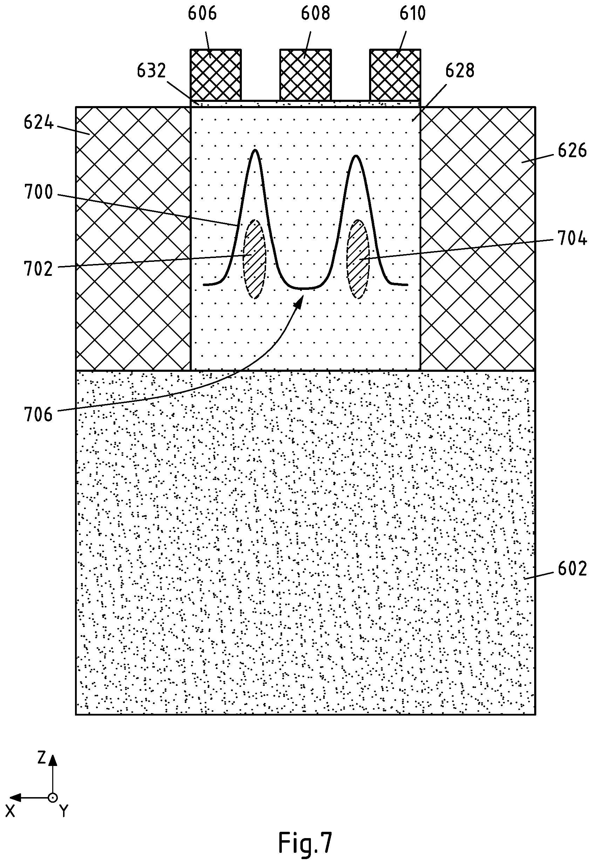

Fig. 7 shows the field-effect transistor element 600 of fig. 6a in a sectional view with a schematic representation of energy distribution 700 over the width of the field-effect transistor element 600.

While in use, a positive voltage may be applied at the three primary gate regions 606, 608, 610, respectively, and a negative voltage may be applied at the secondary gate region 612, while the drain region 626 and the source region 624 serve as reference for electric potential. Then, the first primary gate region 606 together with the second primary gate region 608 effects a lateral confinement for hosting a first quantum dot 702, while the second primary gate region 608 and the third primary gate region 610 effect a lateral confinement for hosting a second quantum dot 704. The second primary gate also effects a modulation of the barrier 706 between the first quantum dot 702 and the second quantum dot 704. When the negative voltage is applied to the secondary gate region 612, a nanowire-like region is electrostatically created in the channel region 618. In the nanowire-like region, the holes are inversed. Following that, primary gate regions 606, 608, 610 applied with positive voltages modulate the valence band energy into 700, where the two quantum dots 702 and 704 are built for tapping holes.

It may be noted that the dimension Lₓ for the field-effect transistor element 100 of fig. 1 to 4 and the dimension Lₓ for the field-effect transistor element 600 of fig. 6 both correspond to the width of a second primary gate region 122, 608 of the at least two primary gate regions 120, 122, 124 and 606, 608, 610 along the x axis and have an analog effect on the formation of a quantum dot. Further, the dimension t_{ch} for the field-effect transistor element 100 of fig. 1 to 4 and the dimension Fw for the field-effect transistor element 600 of fig. 6 both correspond to the thickness of the channel region 106, 628 and have an analog effect on the formation of a quantum dot.

## Claims

1. Field-effect transistor element (100, 500, 600) comprising
- a channel region (106, 628),
- a source region (108, 624),
- a drain region (110, 626), and
- at least two primary gate regions (120, 122, 124, 506, 508, 510, 606, 608, 610), wherein the at least two primary gate regions (120, 122, 124, 506, 508, 510, 606, 608, 610) are respectively provided with a main direction of extension (126, 128, 130, 614, 616, 618), and wherein the respective main directions of extension (126, 128, 130, 614, 616, 618) of the at least two primary gate regions (120, 122, 124, 506, 508, 510, 606, 608, 610) are arranged substantially parallel to each other,
**characterized**
- **in that** at least one secondary gate region (118, 502, 612) having a main direction of extension (132, 620) is provided, and
- **in that** the main direction of extension (132, 620) of the at least one secondary gate region (118, 502, 612) is arranged substantially orthogonally to the respective main directions of extension (126, 128, 130, 614, 616, 618) of the at least two primary gate regions (120, 122, 124, 506, 508, 510, 606, 608, 610).

2. Field-effect transistor element (100, 500, 600) according to claim 1, **characterized**
- **in that** the at least two primary gate regions (120, 122, 124, 506, 508, 510, 606, 608, 610) comprise N primary gate regions (120, 122, 124, 506, 508, 510, 606, 608, 610), wherein N is equal or greater than 2, and
- **in that** the N primary gate regions (120, 122, 124, 506, 508, 510, 606, 608, 610), the channel region (106, 628) and the at least one secondary gate region (118, 502, 612), are configured to, when the N primary gate regions (120, 122, 124, 506, 508, 510, 606, 608, 610) are provided with a positive electrical bias and the at least one secondary gate region (118, 502, 612) is provided with a negative electrical bias, cause N-1 electrostatic confinement(s) of holes in the channel region (106, 628),
- wherein the respective N-1 electrostatic confinement(s) of holes correspond to a quantum dot (408, 416, 702, 704) in the valence band of the channel region (106, 628), respectively.

3. Field-effect transistor element (100, 500, 600) according to any one of the preceding claims,
**characterized**
- **in that** the at least two primary gate regions (120, 122, 124, 506, 508, 510, 606, 608, 610) are arranged spaced at a distance Lₛₚₓ from each other,
- wherein the distance Lₛₚₓ is comprised in the range of 0 to 30 nm, in particular in the range of 5 to 25 nm, more particularly in the range of 5 to 20 nm, preferably in the range of 5 to 15 nm, more preferably in the range of 7 to 13 nm.

4. Field-effect transistor element (100, 500, 600) according to any one of the preceding claims,
**characterized**
- **in that** the at least two primary gate regions (120, 122, 124, 506, 508, 510, 606, 608, 610) comprise a first primary gate region (120, 506, 606), a second primary gate region (122, 508, 608) and a third primary gate region (124, 510, 610), wherein the second primary gate region (122, 508, 608) is arranged between the first primary gate region (120, 506, 606) and the third primary gate region (124, 510, 610), and wherein the second primary gate region (122, 508, 608) has a dimension Lₓ in a direction substantially orthogonal to its respective main direction of extension (128, 616),
- wherein the dimension Lₓ is comprised in the range of 0 to 35 nm, in particular in the range of 0 to 30 nm, more particularly in the range of 0 to 20 nm, preferably in the range of 0 to 10 nm, particularly in the range of 7 to 13 nm.

5. Field-effect transistor element (100, 500, 600) according to any one of the preceding claims,
**characterized**
- **in that** the at least two primary gate regions (120, 122, 124, 506, 508, 510, 606, 608, 610) are arranged spaced at a distance Lₛₚₓ from each other,
- **in that** the at least two primary gate regions (120, 122, 124, 506, 508, 510, 606, 608, 610) comprise a first primary gate region (120, 506, 606), a second primary gate region (122, 508, 608) and a third primary gate region (124, 510, 610), wherein the second primary gate region (122, 508, 608) is arranged between the first primary gate region (120, 506, 606) and the third primary gate region (124, 510, 610), and wherein the second primary gate region (122, 508, 608) has a dimension VGI in a direction substantially orthogonal to its respective main direction of extension (128, 616), and
- **in that** the product of a division of the distance Lₛₚₓ by the distance VGI is comprised in the range from 0.25 to 1.25, in particular in the range from 0.5 to 1.

6. Field-effect transistor element (100, 500, 600) according to any one of the preceding claims,
**characterized**
- **in that** the at least two primary gate regions (120, 122, 124, 506, 508, 510, 606, 608, 610) are arranged spaced at a distance Lₛₚₓ from each other,
- **in that** the at least one secondary gate region (118, 502, 612) has a dimension W_{bg} in a direction substantially orthogonal to its respective main direction of extension (132, 620), and
- **in that** the product of a division of the distance W_{bg} by the distance Lₛₚₓ is comprised in the range from 0.25 to 1.25, in particular in the range from 0. 5 to 1.

7. Field-effect transistor element (100, 500, 600) according to any one of the preceding claims,
**characterized**
- **in that** the channel region (106, 628) comprises a silicon-germanium alloy and / or isotopically purified silicon isotope ²⁸Si.

8. Field-effect transistor element (100, 500) according to any one of the preceding claims,
**characterized**
- **in that** a layer body (102) is provided with a front side (114) and a back side (116) arranged opposite to each other,
- **in that** the at least two primary gate regions (120, 122, 124, 506, 508, 510) are arranged at the front side (114) of the layer body (102), and
- **in that** the at least one secondary gate region (118, 502) is arranged at the back side (116) of the layer body (102).

9. Field-effect transistor element (100, 500) according to claim 8,
**characterized**
- **in that** the layer body (102) comprises a front dielectric layer (104), the source region (108, 624), the drain region (110, 626), the channel region (106, 628) and a back dielectric layer (112),
- wherein the front dielectric layer (104) is arranged at the front side (114) of the layer body (102), the back dielectric layer (112) is arranged at the back side (116) of the layer body (102), and the channel region (106, 628) is arranged between the front dielectric layer (104) and the back dielectric layer (112),
- **in that** the channel region (106, 628) has a thickness t_{ch},
- **in that** the at least two primary gate regions (120, 122, 124, 506, 508, 510) are arranged spaced at a distance Lₛₚₓ from each other,
**in that** the product of a division of the distance Lₛₚₓ by the thickness tch is comprised in the range from 0.25 to 2.25, in particular in the range from 0.5 to 2.

10. Field-effect transistor element (100, 500) according to any one of the preceding claims,
**characterized**
**in that** the field-effect transistor element (100, 500) is the product of a fully depleted silicon on insulator, FD-SOI, method.

11. Field-effect transistor element (600) according to claim 1 to 7,
**characterized**
- **in that** a bulk body (602) is provided with a front side (604), and
- **in that** the at least two primary gate regions (606, 608, 610) and the at least one secondary gate region (612) are arranged at the front side (604) of the bulk body (602).

12. Field-effect transistor element (600) according to claim 11,
**characterized**
- **in that** a primary gate region of the at least two primary gate regions (606, 608, 610) is arranged substantially in a primary main extension plane comprising the respective main direction of extension (614, 616, 618) of the primary gate region,
- **in that** a secondary gate region (612) of the at least one secondary gate region (612) is arranged substantially in a secondary main extension plane comprising the respective main direction of extension (132, 620) of the secondary gate region (612),
- **in that** a fin region (622) with a main direction of extension (630) is provided and arranged substantially in a tertiary main extension plane comprising the main direction of extension (630) of the fin region (622),
- **in that** the primary main extension plane is substantially orthogonal to the secondary main extension plane and to the tertiary main extension plane, and
- **in that** the secondary main extension plane is substantially orthogonal to the tertiary main extension plane.

13. Field-effect transistor element (600) according to claim 12,
**characterized**
- **in that** the fin region (622) has a dimension Fw in a direction substantially orthogonal to the tertiary main extension plane,
- **in that** the at least two primary gate regions (606, 608, 610) are arranged spaced at a distance Lₛₚₓ from each other, and
- **in that** the product of a division of the distance Lₛₚₓ by the dimension Fw is comprised in the range from 0.25 to 2.25, in particular in the range from 0.5 to 2.

14. Quantum computer device comprising at least one field-effect transistor element (100, 500, 600) according to any one of the preceding claims.
